# EUROPEAN PATENT SPECIFICATION

(11) **EP 3 283 433 B1**
(45) Date of publication and mention of the grant of the patent: **01.05.2019**
(21) Application number: 16709349.1
(22) Date of filing: 08.03.2016
(51) Int. Cl.: B81B 7/00

(54) **MEMS SENSOR COMPONENT**
MEMS-SENSORKOMPONENTE
COMPOSANT CAPTEUR MEMS

(30) Priority: 13.04.2015 US 201514685259
(43) Date of publication of application: 21.02.2018
(73) Proprietor: TDK Corporation, Tokyo 108-0023 (JP)
(72) Inventor: PAHL, Wolfgang, 81379 München (DE)
(74) Representative: Epping - Hermann - Fischer
(86) International application number: PCT/EP2016/054919
(87) International publication number: WO 2016/165882

(56) References cited:
- US-A1- 2002 146 919
- US-A1- 2009 232 336
- US-A1- 2012 087 521
- US-A1- 2012 286 380

## Description

### TECHNICAL FIELD

The present invention refers to MEMS sensor components, e.g. to MEMS pressure sensors, MEMS barometric sensors, or MEMS microphones.

### BACKGROUND

MEMS sensor components (MEMS = Micro-Electro-Mechanical System) may comprise a MEMS chip with sensitive functional elements. Further, MEMS sensor components may comprise electric or electronic circuitry to evaluate sensor signals provided by the functional elements.

For example, a MEMS microphone comprises a flexible membrane and a rigid perforated back plate. The membrane and the back plate establish the electrodes of a capacitor. Received sound signals cause the membrane to oscillate. The oscillation of the capacitor's electrode results in an oscillating capacity. By monitoring the capacitor's capacity via electric or electronic circuitry, the sound signal is converted into an electrical signal. Electric components for monitoring the capacitors can be integrated in an ASIC chip (ASIC = Application-Specific Integrated Circuit).

A MEMS sensor component must provide housing elements to mechanically and electrically connect all circuit components and to protect sensitive elements from detrimental environmental conditions.

Further, the ongoing trend towards miniaturization demands smaller components. However, to provide good acoustic properties needed for a sufficiently good electrical signal quality, a large mechanically active region or a large back volume in the case of MEMS microphones is beneficial. Additionally, as structural parts of MEMS sensor components' housings are becoming thinner, an increasing sensitivity to internal and external mechanical stress is observed. Similar circumstances hold true for MEMS barometric pressure sensors which are even more stress sensitive. Such devices detect pressure dependent variations in the deflection of a thin membrane with a width in the sub-nanometer range. A minor stress induced deformation of the membrane can easily interfere with the deflection.

Thus, what is needed is a MEMS sensor component that allows small lateral dimensions, provides a good signal quality, and is robust against internal and/or external mechanical stress.

From US 2013/0193533, MEMS microphones are known. From US 2014/0036466, further MEMS microphones are known.

Patent application US 2002/0146919 describes a MEMS component attached to an ASIC wafer by mechanically compliant springs which absorb stress and also form the electrical connections between the two chips. US 2012/0286380 describes a MEMS chip packaged in a cavity over a CMOS substrate. US 2009/0232336 describes electrical stress-reducing spring connections between a MEMS microphone chip and a substrate which contains electrical connections through the base.

However, the need for MEMS sensor components with a reduced sensitivity to internal and external mechanical stress still exist.

### SUMMARY

A MEMS sensor component according to the invention is defined in claim 1.

A MEMS sensor component with a reduced sensitivity to stress comprises a carrier substrate, an ASIC chip embedded in the carrier substrate, a MEMS chip arranged on or above the carrier substrate, a cap arranged above the carrier substrate, a solder pad at the bottom side of the carrier substrate, an electrical interconnection at least between the ASIC chip and the solder pad, and a connection element. The cap encloses a cavity between the cap and the carrier substrate. The MEMS chip is arranged in the cavity. The connection element is an elastically deformable spring element. The connection element mechanically connects the MEMS chip in a flip-chip configuration to the carrier substrate. The connection element electrically connects the MEMS chip to the interconnection. A soft fixation element mechanically connects the MEMS chip to the carrier substrate.

It is possible and it may be preferred that the connection element is a spring element or a plurality of spring elements, e.g. four, realized as patterned thin metal layer being fixed to the carrier substrate at one end and extends parallel to the carrier substrate but spaced apart from it to the other end. There may be an offset in-plane between corresponding contact points on the carrier substrate and on the MEMS chip. Thus, highly improved compliance is achieved compared to an aligned joint like a solder ball, which is also somewhat elastic in principle.

Typical materials contained in the spring element are Cu, Ni, Al or the like. Further, it is possible that the spring element consists of a metal like Cu, Ni, or Al. Typical dimensions are 5-100 µm in thickness, 10-100 µm in width, and 100-2000 µm in length. The spring constant for the assembly comprising the MEMS soldered onto typically 4 springs is lower than 100 kN/m, preferrably in the order of 0,1-10 kN/m for x-, y-, and z-axis.

In such a sensor component, the MEMS chip is mechanically decoupled from any external or internal stress to which the carrier substrate is exposed as the connection element holds the MEMS chip in its steady state position without transferring a mechanical force large enough to disturb the chip's mechanical functionality. The ASIC chip is embedded in the carrier substrate. However, chips with integrated electronic circuitry are much less susceptible to mechanical forces.

The cap enclosing the cavity protects the MEMS chip and the chip's respective sensitive structural elements from detrimental external influences such as dust particles, corrosive components in the devices' surrounding atmosphere, etc. The flip-chip configuration in which the MEMS chip is mounted to the carrier substrate allows short signal routes and the flexible mounting decoupling the MEMS chip from the substrate.

Conventional flip-chip assemblies rigidly couple the chip to the substrate. Internal or external stress is directly transmitted to the chip and may result in a shift of the sensitivity of the functional structures. Thus, a temperature-induced change in sensitivity of conventional microphones can be obtained. If the temperature-induced change in sensitivity reaches the specification tolerance of a MEMS microphone, a corresponding MEMS microphone shows no stable performance. However, due to the soft support of the MEMS chip via the connection element, the present MEMS sensor component has a vastly increased temperature range of excellent performance.

It is possible that the carrier substrate comprises an organic material.

It is possible that the organic material may comprise a polymer.

In conventional MEMS sensor components, the carrier substrate needed to have a material that resists aggressive chemistry needed to form connection elements at its top side. It was found that an organic material such as a polymer is compatible with structuring steps needed for forming spring like connection element while at the same time being compatible with steps of embedding an ASIC chip in the bulk material of the carrier substrate.

It is further possible that the connection element comprises a metal and has a free-standing end.

Especially for such a connection element, complex manufacturing steps are needed as a sacrificial material needs to be arranged between the top side of the carrier substrate and the later position of the free-standing end. After arranging the metal of the connection element on the sacrificial material, the respective sacrificial material needs to be removed in order to give the needed possibility to move in all directions to the free-standing end of the connection element.

Thus, a polymer was found to be the optimal material to have an ASIC chip embedded and complex connection elements manufactured at its top side.

It is possible that the carrier substrate is a multi-layer substrate and comprises a metallization layer between two dielectric layers.

In the metallization layer, signal conductors or circuit elements such as resistive elements, capacitive elements or inductive elements or phase shifters or similar circuit elements can be structured.

Accordingly, it is possible that the MEMS sensor component comprises such an additional circuit element embedded in the multi-layer substrate. It is further possible that an additional circuit element is an active circuit element, e.g. as part of an additional ASIC circuit or as a part of circuitry not integrated in the ASIC chip.

The additional circuit element may comprise a structured metallization in the metallization layer, in an additional metallization layer above or below the metallization layer or in additional metallization layers above and below the metallization layer. Inductive elements can be realized by coil shaped conductor stripes within the same metallization layer. Capacitive elements can comprise electrodes existing in different metallization layers stacked one above the other.

Via connections can be utilized to electrically connect different circuit elements in different metallization layers and/or connection pads on the top side of the carrier substrate and/or the solder pad at the bottom side of the carrier substrate.

It is possible that the cap seals the cavity.

If the MEMS sensor component establishes a MEMS microphone, then a back volume acoustically decoupled from the microphone's environment is needed to prevent an acoustic short circuit. This back volume may at least partially be arranged in the cavity and the sealing cap prevents sound signals from contaminating the microphone's interior pressure levels. However, it is possible that the cavity has an opening, e.g. a sound opening. The sound entry opening may be realized by a hole. The hole may be arranged in the carrier substrate or in a segment of the cap. The sound entry is needed to conduct acoustic signals to the functional element of the MEMS chip. Thus, it is possible that the cavity comprises at least a segment that is sufficiently sealed from the component's environment.

Accordingly, it is possible that the cap or the carrier substrate comprises an opening, e.g. a sound entry opening which may be realized as a hole.

The soft fixation element may connect the MEMS chip to the carrier substrate and to an inner surface of the cap.

It is possible that the soft fixation component comprises a soft laminate foil or a gel.

It is possible that the soft fixation component comprises a silicone-type gel comprising silicone.

The soft fixation component, e.g. in the form of a silicone-type gel, may support the connection element in holding the MEMS chip in its steady state position without exposing the MEMS chip to internal or external stress.

It is possible that the soft fixation component fills at least a part of the volume between the MEMS chip and the carrier substrate or between the MEMS chip and the cap.

The soft fixation component improves the mechanical damping and the impact shock robustness without the danger of contaminating the MEMS chip's functional elements. The soft fixation element is compatible with most sensor types, such as sensors with springs used to decouple the MEMS chip. The soft fixation component may mainly have the viscose properties of a fluid without the possibility to transmit static forces but with the possibility to remain at its steady state position. Thus, the MEMS chip's sensitive functional elements are not jeopardized.

Accordingly, it is possible that the MEMS chip comprises functional structures, e.g. deflection sensors, membranes, rigid perforated back plates, etc. It is especially possible that the MEMS chip is selected from a microphone chip, a pressure sensor chip, and a barometric sensor chip.

It is possible that a cavity with or without a back volume within the MEMS chip is filled by material of the soft fixation element.

It is possible that the cap comprises an edge and a hole in the edge.

It is also possible that the cap comprises a side portion and a hole in the side portion.

Further, it is possible that the cap comprises a first segment at a first distance from the carrier substrate and a second segment in a second distance from the carrier substrate different from the first distance. Then, a hole is formed in the segment closer to the carrier substrate.

Such embodiments have a hole, e.g. a sound entry hole, in the cap. However, the sensor component can - at least temporarily - be arranged upside down on an auxiliary foil during certain manufacturing steps without the risk of closing the hole. Especially when the auxiliary foil has an adhesive tape to hold the component tightly, the hole cannot be filled by the adhesive.

### BRIEF DESCRIPTION OF THE DRAWINGS

The MEMS sensor component, its basic working principles and various examples are shown in the accompanying figures. In detail,
- FIG. 1: shows a basic construction of the MEMS sensor component,
- FIG. 2: shows an example of a MEMS microphone,
- FIG. 3: shows an embodiment of the MEMS microphone,
- FIG. 4: shows a MEMS sensor component with a back volume closed by a lid,
- FIG. 5: shows an example with a hole in the cap,
- FIG. 6: shows an embodiment with a soft fixation element supporting the connection element in holding the MEMS chip,
- FIG. 7: shows an embodiment where a large volume of the cavity is filled by the soft fixation element,
- FIG. 8: shows an example where a soft fixation element is arranged between the cap and the top side of the MEMS chip and where a hole is arranged in an edge region of the cap,
- FIG. 9: shows an example with a stepped cap comprising different segments in a different distance from the top side of the carrier substrate,
- FIG. 10: shows an example with an integrated capacitive element,
- FIG. 11: shows an example with an integrated inductive element,
- FIG. 12: shows an example with an additional circuit element.

### DETAILED DESCRIPTION OF ILLUSTRATIVE EMBODIMENTS

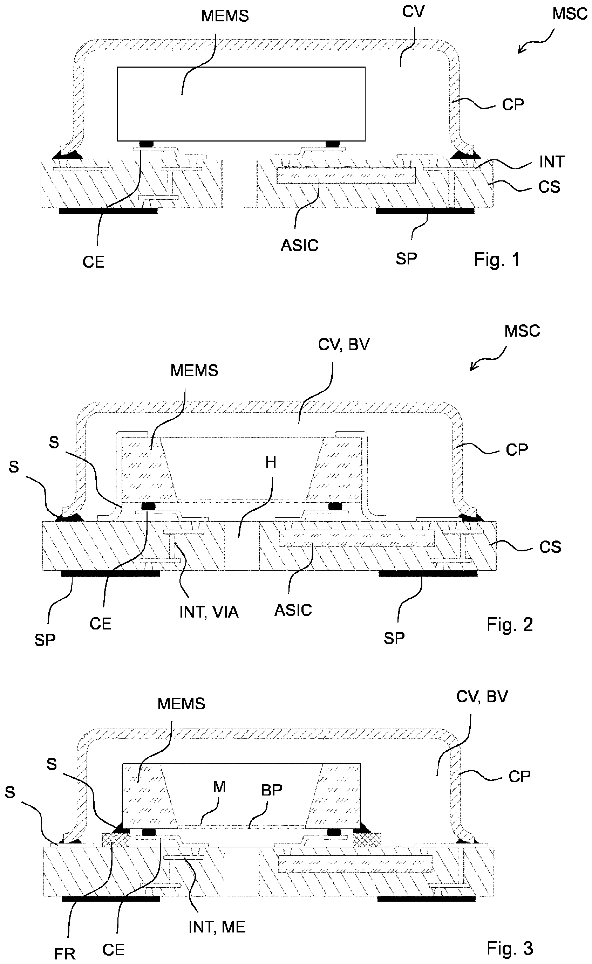

FIG. 1 shows a MEMS sensor component MSC with a MEMS chip MEMS arranged above a carrier substrate CS. Two or more connection elements CE are created at the top side of the carrier substrate CS to electrically connect and mechanically support the MEMS chip MEMS. The connection elements CE comprise a segment directly connected to the carrier substrate CS and an additional segment at a free-standing end directly connected to a solder ball at the bottom side of the MEMS chip MEMS.

Further, an ASIC chip ASIC is embedded in the carrier substrate CS. At the bottom side of the carrier substrate CS, at least two solder pads SP are arranged provided for connecting the MEMS sensor component MSC to an external circuit environment. An interconnection INT comprises a plurality of conductor segments and electrically connects the MEMS chip MEMS, the ASIC chip ASIC and the one or the plurality of solder pads SP.

A cap CP is arranged above the carrier substrate CS and encloses a cavity CV in which the MEMS chip MEMS is arranged.

The MEMS sensor component MSC shown in FIG. 1 comprises a hole through the carrier substrate CS via which the MEMS chip and its sensitive functional structures, respectively, are connected to the components' environment.

FIG. 2 shows a MEMS sensor component being a MEMS microphone. The microphone has the MEMS chip arranged over a hole H in the carrier substrate CS which may work as a sound entry hole. The main portion of the cavity CV acts a back volume BV to prevent an acoustic short circuit. To separate the back volume BV from sound pressure surrounding the microphone, an outer seal S closes possible gaps between the cap CP and the carrier substrate CS. An inner seal S closes possible gaps between the MEMS chip MEMS and the carrier substrate CS. Thus, sound pressure is only applied to the functional structures of the MEMS chip MEMS.

FIG. 3 shows an embodiment of a MEMS microphone where the MEMS chip is sealed with an inner seal S to a frame structure FR arranged on the top side of the carrier substrate. Thus, the membrane M and the back plate BP are only exposed to sound signals entering the hole from one side. Nearly the whole volume of the cavity CV acts as a back volume BV which is beneficial for good acoustic properties while minimizing the overall volume of the microphone. The frame structure FR or at least the material of the inner seal S may comprise a soft material that - in addition to the connection element CE - acts as a shock absorber and mechanically decouples the MEMS chips from internally or externally induced stress while maintaining the MEMS chip MEMS at a steady state position.

A further metallization ME can be arranged on the top side of the carrier substrate. If the cap CP comprises an electrically conductive material, the cap can be connected to a ground potential via the metallization ME to improve the electrical shielding.

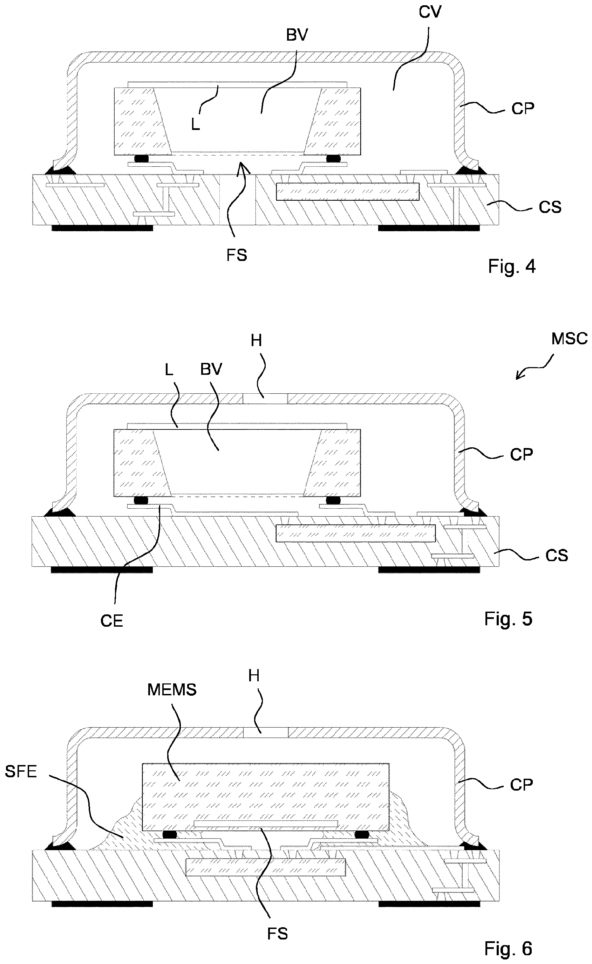

FIG. 4 shows a MEMS microphone where the back volume BV is arranged within an interior section of the MEMS chip and where a lid L separates the back volume BV from other sections of the cavity CV. Signals received from the microphone's environment can be obtained via a hole in the carrier substrate CS. Apart from the functional structures FS of the MEMS chip, other surfaces within the cavity CV but not within the back volume BV are exposed to the external signals. Thus, the cavity CV can comprise further sensor components such as further MEMS chips to gain information about the components' environment.

FIG. 5 shows an example where a hole H is arranged in the cap CP. The back volume BV is sealed by a lid L. No hole needs to be structured through the carrier substrate CS.

FIG. 6 shows an embodiment where an additional soft fixation element supports the MEMS chip MEMS. The soft fixation element may further prevent particles entering the cavity through the hole from getting in direct contact with functional structures FS. However, due to the viscous properties of the soft fixation element, information concerning the components' environment, e.g. atmospheric pressure, can be gained without jeopardizing the mechanical functionality of the functional structures. Further, the MEMS sensor component shown in FIG. 6 could be immersed into a liquid, e.g. during manufacturing steps or during normal operation. Thus, the component can be used as a depth finder for underwater operations.

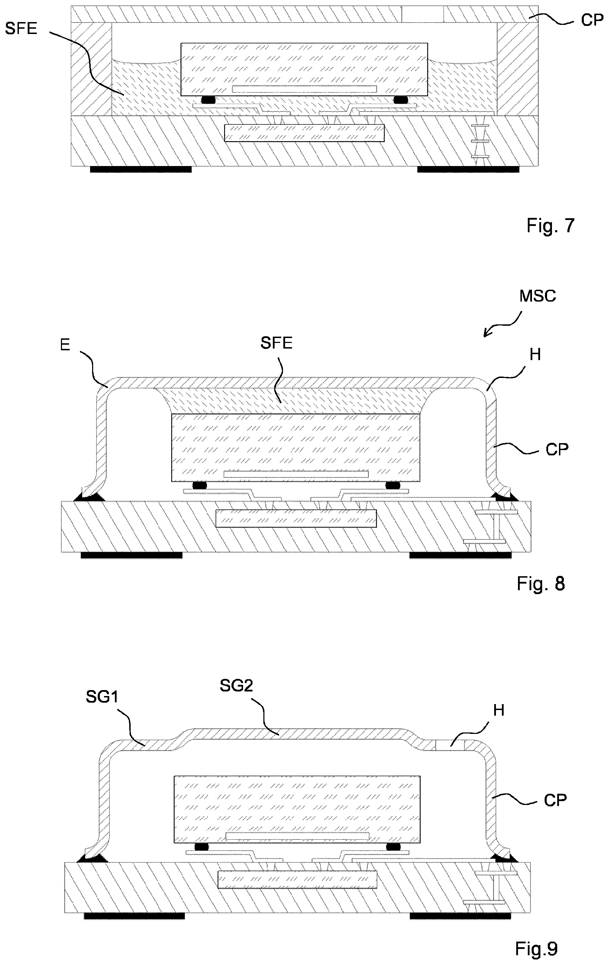

FIG. 7 shows another embodiment of a MEMS sensor component where major parts of the cavity are filled with the soft fixation element where the soft fixation element even touches the functional structures of the MEMS chip. Thus, even if the MEMS chip comprises functional structures sensitive to a corrosive environment, the component can be operated in such a corrosive environment.

FIG. 8 shows an example where the soft fixation element supports the MEMS chip from a position opposite the carrier substrate.

A hole H is arranged in an edge region E of the cap CP. This allows new manufacturing steps where the component or a part of the component, such as the cap CP, is arranged upside down on an auxiliary carrier such as an adhesive auxiliary foil. The adhesive from the auxiliary carrier cannot close the hole H. Then, the soft fixation element can be applied to the inner side of the cap CP when the cap is arranged upside down. Thereafter, the cap CP including the soft fixation element SFE can be pulled over the MEMS chip arranged on the carrier substrate in an upright position.

FIG. 9 shows an example where the cap CP has a first segment SG1 at a first distance from the top side of the carrier substrate and a second segment SG2 at a second distance from the top side of the carrier substrate. The hole H can be arranged in the segment nearer to the carrier substrate. Thus, the cap CP can be arranged upside down on an auxiliary carrier without direct contact to the hole H.

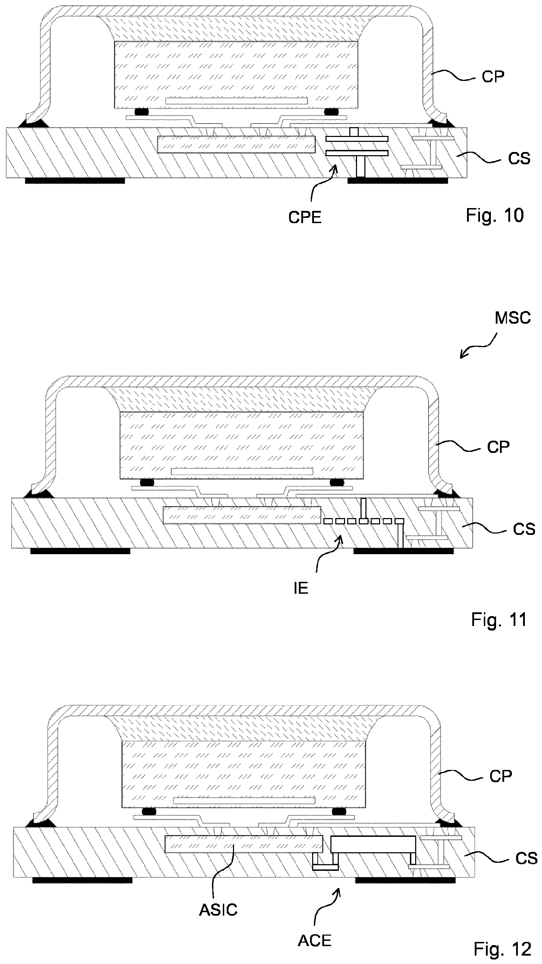

FIG. 10 shows the possibility of arranging additional circuit elements such as passive circuit elements, e.g. a capacitance element CPE, in a multi-layered structure of the carrier substrate CS. Two conductor segments establish the electrodes of the capacitor electrically connected to the interconnection.

FIG. 11 shows the possibility of integrating an inductive element IE in a multi-layered carrier substrate.

FIG. 12 shows the possibility of embedding additional circuit element ACE, e.g. additional integrated circuit chips, in the multi-layered substrate.

The MEMS sensor component is not limited to the features stated above or to the embodiments and examples shown by the figures. Components comprising further circuit elements or connection elements are also comprised by the present invention.

### List of reference signs

- ACE:: additional circuit element
- ASIC:: ASIC chip
- BP:: back plate
- BV:: back volume
- CE:: connection element
- CPE:: capacitance element
- CP:: cap
- CS:: carrier substrate
- CV:: cavity
- FR:: frame
- FS:: functional structures
- H:: hole
- IE:: inductive element
- INT:: interconnection
- L:: lid
- M:: membrane
- ME:: metallization
- MEMS:: MEMS chip
- MSC:: MEMS sensor component
- S:: seal
- SFE:: soft fixation element
- SG1:: first segment of the cap
- SG2:: second segment of the cap
- SP:: solder pad
- VIA:: via connection

## Claims

1. A MEMS sensor component, comprising:
a carrier substrate (CS);
an ASIC (ASIC) embedded in the carrier substrate;
a MEMS (MEMS) arranged on or above the carrier sub¬strate;
a cap (CP) arranged above the carrier substrate, wherein the cap encloses a cavity (CV) and the MEMS chip is arranged in the cavity;
a solder pad (SP) at a bottom side of the carrier substrate;
an electrical intercon¬nection (INT) between the ASIC chip and the solder pad;
a connection element (CE) comprising an elastically deformable spring element, wherein the connection element mechanically connects the MEMS chip in a flip-chip configuration to the carrier substrate and wherein the connection element electrically connects the MEMS chip to the interconnection; and
a soft fixation element (S, SFE) mechanically connecting the MEMS chip to the carrier substrate.

2. The MEMS sensor component according to claim 1, wherein the carrier substrate comprises an organic material.

3. The MEMS sensor component according to claim 2, wherein the carrier substrate comprises a polymer.

4. The MEMS sensor component according to one of the preceeding claims, wherein the connection element comprises a metal and has a freestanding end.

5. The MEMS sensor component according to one of the preceeding claims, wherein the carrier substrate comprises a multilayer substrate that includes a metallization layer between two dielectric layers.

6. The MEMS sensor component according to claim 5, further comprising an additional circuit element embedded in the multilayer substrate, the additional circuit element comprising an active or a passive circuit element.

7. The MEMS sensor component according to claim 6, wherein the additional circuit element comprises a resistive element, an inductive element, or a capacitive element, the additional circuit element comprising structured metallizations in the metallization layer.

8. The MEMS sensor component according to one of the preceeding claims, wherein the cap seals the cavity.

9. The MEMS sensor component according to one of the preceeding claims, wherein the cap or the carrier substrate comprises an opening.

10. The MEMS sensor component according to one of the preceeding claims, wherein the soft fixation element comprises a soft laminate foil or a gel.

11. The MEMS sensor component according to one of the preceeding claims, wherein the soft fixation element comprises a silicone-type gel.

12. The MEMS sensor component according to one of the preceeding claims, wherein the soft fixation element fills at least a part of a volume between the MEMS chip and the carrier substrate or between the MEMS chip and the cap.

13. The MEMS sensor component according to one of the preceeding claims, wherein the soft fixation element also mechanically connects the MEMS chip to the cap as well as to the carrier substrate.

14. The MEMS sensor component according to one of the preceeding claims, wherein the connection element is embedded in the soft fixation element.

15. The MEMS sensor component according to one of the preceeding claims, wherein the MEMS chip comprises functional structures.

16. The MEMS sensor component according to one of the preceeding claims, wherein the MEMS chip comprises a microphone chip, a pressure sensor chip, or a barometric sensor chip.

17. The MEMS sensor component according to one of the preceeding claims, wherein the cap comprises an edge and a hole in the edge.

18. The MEMS sensor component according to one of the preceeding claims, wherein the cap comprises a side portion and a hole in the side portion.

19. The MEMS sensor component according to one of the preceeding claims, wherein the cap comprises a first segment at a first distance from the carrier substrate and a second segment at a second distance from the carrier substrate different from the first distance, a hole being formed in the segment closer to the carrier substrate.

## Patentansprüche

1. MEMS-Sensorkomponente, umfassend:
ein Trägersubstrat (CS);
einen ASIC (ASIC), der in das Trägersubstrat eingebettet ist;
ein MEMS (MEMS), das auf oder über dem Trägersubstrat angeordnet ist;
eine Haube (CP), die über dem Trägersubstrat angeordnet ist, wobei die Haube einen Hohlraum (CV) umschließt und der MEMS-Chip in dem Hohlraum angeordnet ist;
ein Lötkontaktstelle (SP) an einer Unterseite des Trägersubstrats;
eine elektrische Verbindung (INT) zwischen dem ASIC-Chip und der Lötkontaktstelle;
ein Verbindungselement (CE), das ein elastisch verformbares Federelement umfasst, wobei das Verbindungselement den MEMS-Chip in einer Flip-Chip-Konfiguration mit dem Trägersubstrat mechanisch verbindet, und wobei das Verbindungselement den MEMS-Chip mit der Verbindung elektrisch verbindet; und
ein weiches Fixierungselement (S, SFE), das den MEMS-Chip mit dem Trägersubstrat mechanisch verbindet.

2. MEMS-Sensorkomponente nach Anspruch 1, wobei das Trägersubstrat ein organisches Material umfasst.

3. MEMS-Sensorkomponente nach Anspruch 2, wobei das Trägersubstrat ein Polymer umfasst.

4. MEMS-Sensorkomponente nach einem der vorhergehenden Ansprüche, wobei das Verbindungselement ein Metall umfasst und ein frei stehendes Ende aufweist.

5. MEMS-Sensorkomponente nach einem der vorhergehenden Ansprüche, wobei das Trägersubstrat ein mehrschichtiges Substrat umfasst, das eine Metallisierungsschicht zwischen zwei dielektrischen Schichten aufweist.

6. MEMS-Sensorkomponente nach Anspruch 5, die außerdem ein zusätzliches Schaltkreiselement umfasst, das in das mehrschichtige Substrat eingebettet ist, wobei das zusätzliche Schaltkreiselement ein aktives oder ein passives Schaltkreiselement umfasst.

7. MEMS-Sensorkomponente nach Anspruch 6, wobei das zusätzliche Schaltkreiselement ein ohmsches Element, ein induktives Element oder ein kapazitives Element umfasst, wobei das zusätzliche Schaltkreiselement strukturierte Metallisierungen in der Metallisierungsschicht umfasst.

8. MEMS-Sensorkomponente nach einem der vorhergehenden Ansprüche, wobei die Haube den Hohlraum abdichtet.

9. MEMS-Sensorkomponente nach einem der vorhergehenden Ansprüche, wobei die Haube oder das Trägersubstrat eine Öffnung umfasst.

10. MEMS-Sensorkomponente nach einem der vorhergehenden Ansprüche, wobei das weiche Fixierungselement eine weiche Laminatfolie oder ein Gel umfasst.

11. MEMS-Sensorkomponente nach einem der vorhergehenden Ansprüche, wobei das weiche Fixierungselement ein silikonartiges Gel umfasst.

12. MEMS-Sensorkomponente nach einem der vorhergehenden Ansprüche, wobei das weiche Fixierungselement mindestens einen Teil eines Volumens zwischen dem MEMS-Chip und dem Trägersubstrat oder zwischen dem MEMS-Chip und der Haube ausfüllt.

13. MEMS-Sensorkomponente nach einem der vorhergehenden Ansprüche, wobei das weiche Fixierungselement den MEMS-Chip auch sowohl mit der Haube als auch mit dem Trägersubstrat mechanisch verbindet.

14. MEMS-Sensorkomponente nach einem der vorhergehenden Ansprüche, wobei das Verbindungselement in das weiche Fixierungselement eingebettet ist.

15. MEMS-Sensorkomponente nach einem der vorhergehenden Ansprüche, wobei der MEMS-Chip funktionelle Strukturen umfasst.

16. MEMS-Sensorkomponente nach einem der vorhergehenden Ansprüche, wobei der MEMS-Chip einen Mikrofon-Chip, einen Drucksensorchip oder einen barometrischen Sensorchip umfasst.

17. MEMS-Sensorkomponente nach einem der vorhergehenden Ansprüche, wobei die Haube einen Rand und eine Öffnung in dem Rand umfasst.

18. MEMS-Sensorkomponente nach einem der vorhergehenden Ansprüche, wobei die Haube einen Seitenabschnitt und eine Öffnung in dem Seitenabschnitt umfasst.

19. MEMS-Sensorkomponente nach einem der vorhergehenden Ansprüche, wobei die Haube ein erstes Segment in einem ersten Abstand von dem Trägersubstrat und ein zweites Segment in einem zweiten Abstand von dem Trägersubstrat umfasst, der verschieden von dem ersten Abstand ist, wobei in dem näher zu dem Trägersubstrat liegenden Segment eine Öffnung gebildet ist.

## Revendications

1. Composant capteur MEMS, comprenant :
un substrat de support (CS) ;
un ASIC (ASIC) incorporé dans le substrat de support ;
un MEMS (MEMS) disposé sur ou par-dessus le substrat de support ;
une encapsulation (CP) disposée par-dessus le substrat de support, l'encapsulation fermant une cavité (CV) et la puce MEMS étant disposée dans la cavité ;
une plage d'accueil (SP) sur un côté inférieur du substrat de support ;
une interconnexion électrique (INT) entre la puce ASIC et la plage d'accueil ;
un élément de connexion (CE) comprenant un élément faisant ressort déformable élastiquement, l'élément de connexion reliant mécaniquement la puce MEMS dans une configuration de puce retournée au substrat de support et l'élément de connexion reliant électriquement la puce MEMS à l'interconnexion ; et
un élément de fixation souple (S, SFE) reliant mécaniquement la puce MEMS au substrat de support.

2. Composant capteur MEMS selon la revendication 1, dans lequel le substrat de support comprend un matériau organique.

3. Composant capteur MEMS selon la revendication 2, dans lequel le substrat de support comprend un polymère.

4. Composant capteur MEMS selon une des revendications précédentes, dans lequel l'élément de connexion comprend un métal et a une extrémité sans appui.

5. Composant capteur MEMS selon une des revendications précédentes, dans lequel le substrat de support comprend un substrat multicouche qui comporte une couche de métallisation entre deux couches diélectriques.

6. Composant capteur MEMS selon la revendication 5, comprenant en outre un élément de circuit supplémentaire incorporé dans le substrat multicouche, l'élément de circuit supplémentaire comprenant un élément de circuit actif ou passif.

7. Composant capteur MEMS selon la revendication 6, dans lequel l'élément de circuit supplémentaire comprend un élément résistif, un élément inductif ou un élément capacitif, l'élément de circuit supplémentaire comprenant des métallisations structurées dans la couche de métallisation.

8. Composant capteur MEMS selon une des revendications précédentes, dans lequel l'encapsulation scelle la cavité.

9. Composant capteur MEMS selon une des revendications précédentes, dans lequel l'encapsulation ou le substrat de support comprend une ouverture.

10. Composant capteur MEMS selon une des revendications précédentes, dans lequel l'élément de fixation souple comprend une feuille stratifiée souple ou un gel.

11. Composant capteur MEMS selon une des revendications précédentes, dans lequel l'élément de fixation souple comprend un gel de type silicone.

12. Composant capteur MEMS selon une des revendications précédentes, dans lequel l'élément de fixation souple remplit au moins une partie d'un volume entre la puce MEMS et le substrat de support ou entre la puce MEMS et l'encapsulation.

13. Composant capteur MEMS selon une des revendications précédentes, dans lequel l'élément de fixation souple relie aussi mécaniquement la puce MEMS à l'encapsulation ainsi qu'au substrat de support.

14. Composant capteur MEMS selon une des revendications précédentes, dans lequel l'élément de connexion est incorporé dans l'élément de fixation souple.

15. Composant capteur MEMS selon une des revendications précédentes, dans lequel la puce MEMS comprend des structures fonctionnelles.

16. Composant capteur MEMS selon une des revendications précédentes, dans lequel la puce MEMS comprend une puce de microphone, une puce de capteur de pression, ou une puce de capteur barométrique.

17. Composant capteur MEMS selon une des revendications précédentes, dans lequel l'encapsulation comprend un bord et un trou dans le bord.

18. Composant capteur MEMS selon une des revendications précédentes, dans lequel l'encapsulation comprend une partie latérale et un trou dans la partie latérale.

19. Composant capteur MEMS selon une des revendications précédentes, dans lequel l'encapsulation comprend un premier segment à une première distance du substrat de support et un deuxième segment à une deuxième substance du substrat de support différente de la première distance, un trou étant formé dans le segment plus proche du substrat de support.
